# EUROPÄISCHE PATENTSCHRIFT

(11) **EP 2 088 369 B1**
(45) Veröffentlichungstag und Bekanntmachung des Hinweises auf die Patenterteilung: **08.04.2015**
(21) Anmeldenummer: 09001605.6
(22) Anmeldetag: 05.02.2009
(51) Int. Cl.: F21K 99/00, F21V 31/04, F21V 29/00, F21V 15/01

(54) **Beleuchtungskörper**
Illuminant
Lampe

(30) Priorität: 07.02.2008 AT 2022008
(43) Veröffentlichungstag der Anmeldung: 12.08.2009
(73) Patentinhaber: Schrutek, Elmar, 1140 Wien (AT); Asma gmbh, 3970 Weitra (AT)
(72) Erfinder: Schrutek, Elmar, 1140 Wien (AT)
(74) Vertreter: Krause, Peter

(56) Entgegenhaltungen:
- WO-A-03/089841
- WO-A-2007/013121
- WO-A-2007/131123
- DE-A1-102004 015 730
- US-A1- 2006 012 991
- US-A1- 2007 058 377
- US-A1- 2007 183 156

## Beschreibung

Die Erfindung betrifft einen Beleuchtungskörper, insbesondere für eine Außenbeleuchtung im Freien, der mindestens eine Leuchtdiode mit einer Elektronik umfasst, wobei in einem wannenförmigen Metallgehäuse eine Platine am Metallgehäuse mit direktem Wärmeübergang angeordnet ist und auf der dem Wannengehäuse abgewandten Seite der Platine die in Richtung der Lichtaustrittsöffnung weisende Leuchtdiode angeordnet ist und wobei dieser Aufbau, nämlich Platine, Leuchtdiode mit Elektronik, von den Seitenflächen des wannenförmigen Metallgehäuses deutlich überragt und mit einer Vergussmasse in dem Metallgehäuse vollständig vergossen ist.

Aus der WO 2007/131123 A2 ist eine eingangs erwähnte Beleuchtungsvorrichtung bekannt, die aus einem extrudierten Alu-Gehäuse besteht, auf dessen Boden innen eine Metallkernplatine mit LEDs montiert sind. Der Innenraum des Gehäuses ist mit transparentem lichtechtem Polyurethan, das die die Dioden, die Elektronik und die Platine dicht umschließt, wasserdicht ausgegossen.

Weiters ist aus der US 2007/058377 A1 ein Beleuchtungskörper bekannt, der im Wesentlichen der oben aufgezeigten Beleuchtungsvorrichtung entspricht, wobei jedoch dieser bekannte Beleuchtungskörper keine vergossene Elektronik aufweist.

Aus der EP 1 876 646 A2 ist eine LED-Leuchte mit integrierter Elektronik zur Ansteuerung der LED's bekannt. Diese Leuchte ist für beengte, gegebenenfalls feuchte, Raumverhältnisse, wie Stallungen oder Käfige vorgesehen. Bei dieser Leuchte sind die LED in einem Gehäuse vorgesehen, wobei die Elektronik in dem Gehäuse vergossen wird. Als Alternative kann die Elektronik mit der montierten LED ohne Verwendung eines Gehäuses in Kunstharz vergossen werden. Nachteilig bei dieser Leuchte ist, dass eine genügende Wärmeabfuhr nicht gewährleistet ist, wodurch die Lebenszeit der LED stark beeinträchtigt ist.

Ferner ist aus der WO 98/11946 eine Beleuchtungsanlage für Stallungen, beispielsweise die Hühnerhaltung mit Einzelleuchten, bekannt.

Darüber hinaus ist aus der EP 1 477 729 eine weitere Beleuchtungsvorrichtung für Geflügel-Haltungsanlagen bekannt, bei der einzelne Leuchten in verschiedenen Etagen benutzt werden.

Die WO 2007/013121 offenbart alle Merkmale des Oberbegriffs des Anspruchs 1.

Alle oben aufgezeigten Beleuchtungen finden jedoch in Räumen, auch wenn diese schmutz- und feuchtigkeitsbelastet sind, Verwendung.

Die Aufgabe der Erfindung ist es, einen Beleuchtungskörper der eingangs genannten Art zu schaffen, der einerseits die obigen Nachteile vermeidet und der anderseits im Freien, mit allen Umwelteinflüssen und Belastungen, eingesetzt werden kann.

Die Aufgabe wird durch die Erfindung gelöst.

Der erfindungsgemäße Beleuchtungskörper ist dadurch gekennzeichnet, dass der Verguss als zweischaliger Verguss ausgeführt ist, wobei im Bereich der Leuchtdiode mit der Elektronik ein Verguss mit einer auf Polyurethan-Basis bestehenden Vergussmasse mit geringer Shore-Härte, beispielsweise 40 bis 70 Sh.A, und im Bereich der Lichtaustrittsöffnung ein Verguss mit einer auf Polyurethan-Basis bestehenden Vergussmasse mit hoher Shore-Härte, beispielsweise 30 bis 80 Sh.D, vorgesehen ist und der Verguss im Bereich seines Überganges von hart auf weich eine als Sekundärlinse für eine Fokussierung des Lichtes ausgebildete Zone aufweist, die insbesondere durch Form des Vergusses und die Art der Zusammensetzung der Vergussmasse gegeben ist. Mit der Erfindung ist es erstmals möglich einen Beleuchtungskörper mit LED's zu schaffen, der vollständig vergossen ist und somit in der freien Umwelt eingesetzt werden kann. Mit dieser Vergusstechnik ist ein Systemverguss möglich, der einerseits komplett elastisch und trotzdem eine harte Oberfläche aufweisen kann. Durch die Sekundärlinse können optische Effekte erreicht werden, beispielsweise eine Umlenkung der Leuchtrichtung oder eine asymmetrische Lichtführung. Auf Grund der Geometrie der Sekundärlinse können also die Lichtstrahlen entsprechend beeinflusst bzw. gelenkt werden.

Die Schutzart die durch den Verguss erreicht wird, ist mindestens IP 65. Ferner kann durch den vollständigen Verguss die Lichtaustrittsfläche belastet werden. So kann also der erfindungsgemäße Beleuchtungskörper auch in Gehwegen und Strassen eingebaut werden, wobei die Lichtaustrittsfläche einen Teil der begehbaren Fläche bzw. der Fahrbahn bildet. Die Wärmeabfuhr aus dem Inneren des Beleuchtungskörpers erfolgt über die Metallkernplatine in das Metallgehäuse.

Wie ja an sich bekannt, sind LED sehr temperaturempfindlich. Bei kleinen Überschreitungen der maximalen Temperatur erfolgt eine eklatante Verkürzung der Lebensdauer. Mit dem erfindungsgemäßen Wärmeübergang von LED auf Metallkernplatine und Gehäuse ist die erforderliche Wärmeabfuhr aus dem Inneren gewährleistet.

Als LED bzw. Leuchtdiode kann eine Hochleistungs-Leuchtdiode, das sind Lichtquellen mit hoher Lichtausbeute bei geringem Platzbedarf, mit direkt angeordneter Linse Verwendung finden.

Nach einem weiteren Merkmal der Erfindung ist die Vergussmasse lichtecht, optisch neutral und wasserdicht. Insbesondere ist es vorteilhaft, dass die Vergussmasse UV-beständig ist.

Gemäß einem weiteren besonderen Merkmal der Erfindung ist die Vergussmasse ein Gießsystem, insbesondere ein Kaltgießsystem, vorzugsweise ein elastomeres Polyurethan, bestehend im Wesentlichen aus Isocyanat und Polyol. Eine derartige Vergussmasse hat bei den Versuchen Ergebnisse gezeigt, die den Entwicklungsvorgaben vollends entsprochen hat. Insbesondere verursachen die Materialausdehnungen keine Beschädigung der elektronischen Komponenten im Inneren.

Gemäß einer weiteren Ausgestaltung der Erfindung ist die Kontaktfläche der Metallkernplatine mit dem Metallgehäuse mit einer Wärmeleitpaste oder einer Wärmeleitfolie versehen. Dadurch kann der Wärmeübergang noch besser gestaltet und sichergestellt werden.

Nach einer Weiterbildung der Erfindung sind die Anschlüsse für die Elektronik und die Leuchtdiode bzw. Leuchtdioden im Bereich der Kontaktfläche Metallkernplatine und Metallgehäuse über eine Anbauverschraubung nach außen geführt. Mit einer derartigen Anschlusseinrichtung kann in vorteilhafterweise die Wasserdichtheit gewährleistet werden.

Gemäß einem besonderen Merkmal der Erfindung weist die Elektronik, insbesondere die Steuerelektronik, einen Temperatursensor auf, der die Temperatur der Hot-Spot-Stelle der Leuchtdiode indirekt erfasst. Dadurch ist es möglich, eine Kontrolle über die im Betrieb herrschende Temperatur nahe der Lichtquelle zu erlangen.

Nach einem weiteren besonderen Merkmal der Erfindung umfasst die Elektronik, insbesondere die Steuerelektronik, einen Stromregler mit vorzugsweiser Dimmfunktion, wobei der Stromregler vom Temperatursensor angesteuert ist. Durch diesen Einsatz der Elektronik mit der thermischen Überwachung der LEDs ist eine Leistungserhöhung möglich, ohne dass ein Einfluss auf die Lebensdauer gegeben ist.

Gemäß einer besonderen Ausgestaltung der Erfindung sind die Elektroniken miteinander verbunden und an einen Stromregler mit Dimmfunktion angeschlossen, wobei der Stromregler von den Temperatursensoren angesteuert ist. Die Dimmfunktion ist derart konzipiert, dass bei Überschreiten der maximalen Temperatur eines Hot-Spot Temperatursensors das gesamte Beleuchtungssystem geregelt wird. Man kann das System derart regeln, dass es praktisch zu keinen Helligkeitsunterschieden der geregelten LEDs kommt. Alle Leuchtdioden eines Systems werden auf die gleichen Helligkeitswerte geregelt, da unterschiedliche Helligkeitswerte manchmal sehr unangenehm empfunden werden können. Anderseits kann die Regelung derart gestaltet werden, dass bei Verwendung von Farb-LED's gewünschte Lichtfarben und Strahlungsintensitäten erreicht werden.

Die Erfindung wird an Hand eines Ausführungsbeispieles, das in der Zeichnung dargestellt ist, näher erläutert.

### Es zeigen:

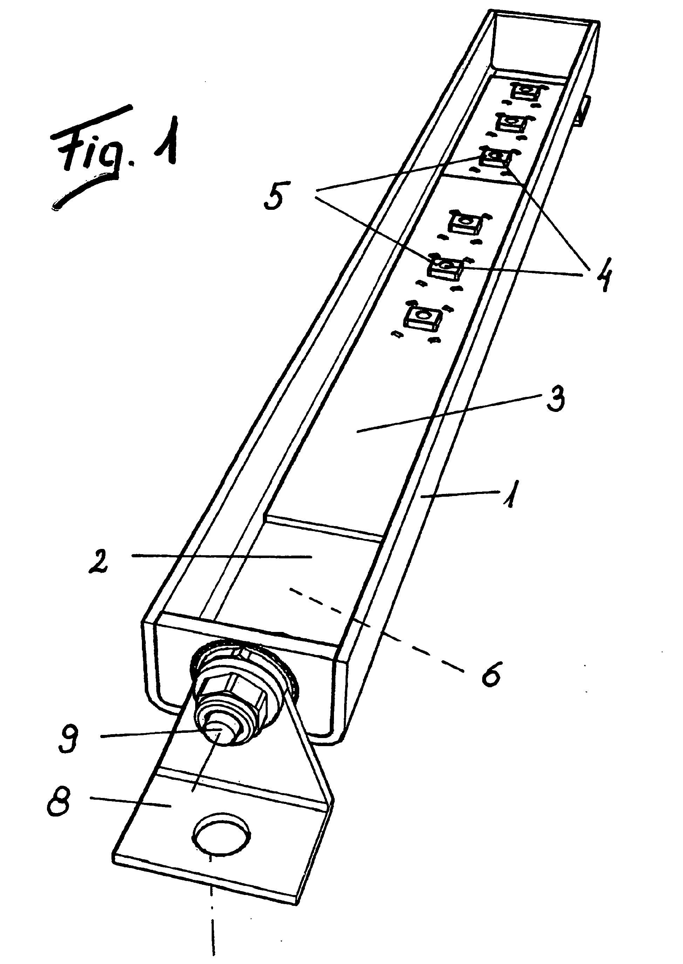

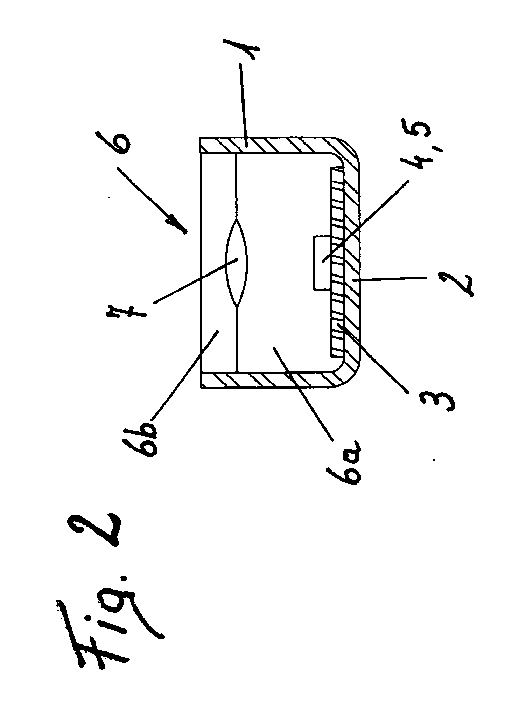

Fig. 1 eine dreidimensionale Ansicht eines Beleuchtungskörpers und Fig. 2 einen Schnitt durch den konstruktiven Aufbau.

Gemäß der Fig. 1 ist ein Beleuchtungskörper für eine Außenbeleuchtung im Freien dargestellt. In einem wannenförmigen Metallgehäuse 1 ist an dessen Bodenfläche 2 eine Metallkernplatine 3 mit direktem Wärmeübergang angeordnet. Auf der Metallkernplatine 3 sind in Richtung der Lichtaustrittsöffnung Leuchtdioden 4, so genannte LED, angeordnet. Die LED's weisen eine integrierte Elektronik 5, insbesondere eine Steuerelektronik für vorzugsweise jede Leuchtdiode 4 auf. Die Leuchtdiode 4 bzw. Leuchtdioden sind Hochleistungs-Leuchtdiode mit direkt angeordneter Linse.

Natürlich kann die Bestückung der LED verschiedenfarbig, nach Kundenwunsch, erfolgen. Bevorzugt kann ein LED-Strahler mit drei primäroptik-LED's und einem Abstrahlungswinkel von 40° hergestellt werden. Vorwiegend wird eine Nennversorgungsspannung von 24 V zum Einsatz kommen. Entsprechend dem Einsatz von Farb-LED's kann die Nennleistung des Beleuchtungskörpers bei 3,5 bis 9,2 W liegen. Die Ansteuerung der Leuchtdioden 4 erfolgt vorzugsweise über ein Pulsweitenmodulations-Signal.

Bei einem Einsatz von LED mit der Lichtfarbe rot, gelb, blau und grün kann eine überaus große Farbpalette an Licht erzeugt werden. Denkbare resultierende Farben sind beispielsweise stahlblau oder weinrot.

Der Aufbau, nämlich Metallkernplatine 3, Leuchtdiode 4 bzw. Leuchtdioden mit ihrer Elektronik 5, werden von den Seitenflächen des wannenförmigen Metallgehäuses 1 deutlich überragt. Dieser Aufbau wird mit einer - in der Fig. 1 nicht sichtbar dargestellten - Vergussmasse 6 in dem Metallgehäuse 1 feuchtigkeitsdicht und vollständig vergossen. Eine Mindestschutzart von IP 65 kann problemlos erreicht werden.

Zur Befestigung des Beleuchtungskörpers im Freien können am Metallgehäuse 1, außen angeordnete, Befestigungsmittel 9 für Halterungen 8 vorgesehen werden. Der Beleuchtungskörper kann mit seinem Metallgehäuse 1 jedoch vorzugsweise auch in Gehwegen oder Fahrbahnen versenkt eingebaut werden. Eine beispielhafte Anwendung wäre es, diesen Beleuchtungskörper vor Bahnübergängen in die Strasse einzubauen, um die Sicherheit zu erhöhen.

Natürlich könnte der Beleuchtungskörper auch an Brücken zur optischen Bereicherung eines Stadtbildes montiert werden.

Der komplett vergossene Beleuchtungskörper ist wasserdicht gekapselt und trotzt allen erdenklichen Witterungseinflüssen. Auch eine intensive Sonneneinstrahlung führt zu keinen Schädigungen, da die Vergussmasse 6 als elastische Masse alle Wärmeausdehnungen ausgleicht.

Gemäß der Fig. 2 ist in dem wannenförmigen Metallgehäuse 1 die Metallkernplatine 3 mit einem direkten Wärmeübergang angeordnet. Für einen noch besseren Wärmeübergang ist die Kontaktfläche der Metallkernplatine 3 mit dem Metallgehäuse 1 mit einer Wärmeleitpaste oder einer Wärmeleitfolie versehen. Die elektrischen Anschlüsse für die Elektronik 5 und die Leuchtdiode 4 bzw. Leuchtdioden sind - in der Fig. 2 nicht dargestellt - im Bereich der Kontaktfläche Metallkernplatine 3 und Metallgehäuse 1 über eine Anbauverschraubung nach außen geführt.

Die Elektronik 5, insbesondere die Steuerelektronik, umfasst einen - nicht dargestellten - Temperatursensor, der die Temperatur der Hot-Spot-Stelle der Leuchtdiode 4 indirekt erfasst. Weiters umfasst die Elektronik 5, insbesondere die Steuerelektronik, einen - ebenfalls nicht dargestellten - Stromregler mit einer Dimmfunktion, wobei der Stromregler vom Temperatursensor angesteuert wird.

Dieser Aufbau, nämlich die Metallkernplatine 3, die Leuchtdiode 4 bzw. Leuchtdioden mit ihrer Elektronik 5, werden, wie bereits erwähnt, von den Seitenflächen des wannenförmigen Metallgehäuses 1 deutlich überragt und dieser Aufbau wird mit einer Vergussmasse 6 in dem Metallgehäuse 1 feuchtigkeitsdicht und vollständig vergossen.

Die Vergussmasse 6 ist insbesondere ein Kaltgießsystem, vorzugsweise ein elastomeres Polyurethan, bestehend im Wesentlichen aus Isocyanat und Polyol. Die Vergussmasse 6 ist ferner lichtecht, optisch neutral und wasserdicht.

Für besondere Verwendungszwecke des Beleuchtungskörpers ist der Verguss als zweischaliger Verguss ausgeführt. Im Bereich der Leuchtdiode 4 ist ein Verguss 6a mit einer auf Polyurethan-Basis bestehenden Vergussmasse mit geringer Shore-Härte, beispielsweise 40 bis 70 Sh.A, und im Bereich der Lichtaustrittsöffnung ein Verguss 6b mit einer auf Polyurethan-Basis bestehenden Vergussmasse mit hoher Shore-Härte, beispielsweise 30 bis 80 Sh.D, vorgesehen. Mit dieser Vergusstechnik ist ein Systemverguss möglich, der einerseits im Bereich der LED komplett elastisch ist und der anderseits eine harte Oberfläche aufweist. Es ist durchaus im Bereich des Möglichen, dass die Oberfläche der Vergussmasse 6 mittels Hochdruckreiniger gereinigt wird und einr Behandlung mittels Sandstrahlen mit einem Druck von 7 bar, während einer Zeit von 30 Sekunden, ohne Zerstörung widersteht.

Für ganz spezielle Verwendungszwecke und optische Effekte, beispielsweise eine Umlenkung der Leuchtrichtung oder eine asymmetrische Lichtführung, ist der Verguss im Bereich seines Überganges von hart auf weich als Sekundärlinse 7 für eine Fokussierung des Lichtes ausgebildet. Diese Zone wird insbesondere durch die Form des Vergusses und die Art der Zusammensetzung der Vergussmasse 6 hergestellt.

## Patentansprüche

1. Beleuchtungskörper, insbesondere für eine Außenbeleuchtung im Freien, der mindestens eine Leuchtdiode (4) mit einer Elektronik (5) umfasst, wobei in einem wannenförmigen Metallgehäuse (1) eine Platine am Metallgehäuse (1) mit direktem Wärmeübergang angeordnet ist und auf der dem Wannengehäuse abgewandten Seite der Platine die in Richtung der Lichtaustrittsöffnung weisende Leuchtdiode (4) angeordnet ist und wobei dieser Aufbau, nämlich Platine, Leuchtdiode (4) mit Elektronik (5), von den Seitenflächen des wannenförmigen Metallgehäuses (1) überragt und mit einer Vergussmasse (6) in dem Metallgehäuse (1) vollständig vergossen ist, wobei der Verguss als zweischaliger Verguss ausgeführt ist, **dadurch gekennzeichnet, dass** im Bereich der Leuchtdiode (4) mit der Elektronik (5) ein Verguss (6a) mit einer auf Polyurethan-Basis bestehenden Vergussmasse mit geringer Shore-Härte, beispielsweise 40 bis 70 Sh.A, und im Bereich der Lichtaustrittsöffnung ein Verguss (6b) mit einer auf Polyurethan-Basis bestehenden Vergussmasse mit hoher Shore-Härte, beispielsweise 30 bis 80 Sh.D, vorgesehen ist und der Verguss im Bereich seines Überganges von hart auf weich eine als Sekundärlinse (7) für eine Fokussierung des Lichtes ausgebildete Zone aufweist, die insbesondere durch Form des Vergusses und die Art der Zusammensetzung der Vergussmasse gegeben ist.

2. Beleuchtungskörper nach Anspruch 1, **dadurch gekennzeichnet, dass** die Vergussmasse (6) lichtecht, optisch neutral und wasserdicht ist.

3. Beleuchtungskörper nach Anspruch 1 oder 2, **dadurch gekennzeichnet, dass** die Vergussmasse (6) ein Gießsystem, insbesondere ein Kaltgießsystem, vorzugsweise ein elastomeres Polyurethan, bestehend im Wesentlichen aus Isocyanat und Polyol, ist.

4. Beleuchtungskörper nach einem der Ansprüche 1 bis 3, **dadurch gekennzeichnet, dass** die Kontaktfläche der Metallkernplatine (3) mit dem Metallgehäuse (1) mit einer Wärmeleitpaste oder einer Wärmeleitfolie versehen ist.

5. Beleuchtungskörper nach einem der Ansprüche 1 bis 4, **dadurch gekennzeichnet, dass** die Anschlüsse für die Elektronik (5) und die Leuchtdiode (4) bzw. Leuchtdioden im Bereich der Kontaktfläche Metallkernplatine (3) und Metallgehäuse (1) über eine Anbauverschraubung nach außen geführt sind.

6. Beleuchtungskörper nach einem der Ansprüche 1 bis 5, **dadurch gekennzeichnet, dass** die Elektronik (5) eine Steuerelektronik ist und einen Temperatursensor aufweist, der die Temperatur der Hot-Spot-Stelle der Leuchtdiode (4) indirekt erfasst.

7. Beleuchtungskörper nach einem der Ansprüche 1 bis 6, **dadurch gekennzeichnet, dass** die Elektronik (5) einen Stromregler mit vorzugsweiser Dimmfunktion umfasst, wobei der Stromregler vom Temperatursensor angesteuert ist.

8. Beleuchtung nach einem der Ansprüche 1 bis 7, **dadurch gekennzeichnet, dass** die Elektroniken (5) miteinander verbunden sind und an einen Stromregler mit Dimmfunktion angeschlossen sind, wobei der Stromregler von den Temperatursensoren angesteuert ist.

## Claims

1. Lighting fixture, in particular for an exterior lighting outdoors, comprising at least one light emitting diode (4) with electronics (5), wherein in tray-shaped metal housing (1) a printed circuit board is arranged on the metal housing (1) with direct heat transfer and the light emitting diode (4) directed towards the light emission aperture is arranged on the side of the printed circuit board facing away from the tray housing and wherein this assembly, namely printed circuit board, light emitting diode (4) with electronics (5), is surpassed by the side faces of the tray-shaped metal housing (1) and completely sealed in the metal casing (1) with a casting compound (6), wherein the casting is designed as double-shell encapsulation, **characterised in that** in the area of the light emitting diode (4) with the electronics (5) an encapsulation (6a) with a polyurethane-based casting compound with a low Shore hardness, for example 40 to 70 Sh.A, and in the area of the light emission aperture an encapsulation (6b) with a polyurethane-based casting compound with a high Shore hardness, for example 30 to 80 Sh.D, is provided and the casting, in the area of its transition from hard to soft, has a zone designed as secondary lens (7) for focussing the light, which is given in particular by the shape of the encapsulation and the type of composition of the casting compound.

2. Lighting fixture in accordance with claim 1, **characterised in that** the casting compound (6) is non-fading, optically neutral and waterproof.

3. Lighting fixture in accordance with claim 1 or 2, **characterised in that** the casting compound (6) is a runner system, in particular a cold runner system, preferably an elastomeric polyurethane, consisting essentially of isocyanate and polyol.

4. Lighting fixture in accordance with one of claims 1 to 3, **characterised in that** the contact area of the metal core printed circuit board (3) with the metal housing (1) is provided with a thermally conductive paste or a thermally conductive film.

5. Lighting fixture in accordance with one of claims 1 to 4, **characterised in that** the connections for the electronics (5) and the light emitting diode (4) or light emitting diodes in the region of the contact area of the metal core printed circuit board (3) and the metal housing (1) are guided outwardly via an attached screw fitting.

6. Lighting fixture in accordance with one of claims 1 to 5, **characterised in that** the electronics (5) are control electronics and comprise a temperature sensor which indirectly detects the temperature at the hotspot location of the light emitting diode (4).

7. Lighting fixture in accordance with one of claims 1 to 6, **characterised in that** the electronics (5) comprise a current regulator with a preferably dimming function, wherein the current regulator is controlled by the temperature sensor.

8. Lighting in accordance with one of claims 1 to 7, **characterised in that** the electronics (5) are connected with each other and are connected to a current regulator with a dimming function, wherein the current regulator is controlled by the temperature sensors.

## Revendications

1. Luminaire à utiliser notamment pour l'éclairage à l'extérieur, comprenant au moins une diode lumineuse (4) équipée d'un organe électronique (5) une platine étant disposé sur un boîtier métallique (1), de la forme d'un bac et à transfert direct de la chaleur. Côté extrados de la platine, il y a la diode lumineuse (4) donnant sur l'orifice de sortie de la lumière. Cet arrangement de la platine, la diode lumineuse (4), l'organe électronique (5) étant surplombé des faces latérales du boîtier métallique de la forme d'un bac (5), lequel boîtier (1) est complètement rempli d'une masse de scellement (6). Exécution en double du scellement, ce dernier ayant de particulier qu'il y a dans l'endroit de la diode lumineuse (4) et de l'organe électronique (5) un scellement (6a) réalisé à l'aide d'une masse à base de polyuréthane à faible dureté shore allant par exemple de 40 à 70 Sh.A. Une autre particularité de ce scellement en double est qu'il y a à l'endroit de l'orifice de sortie de la lumière, un scellement (6b) réalisé à l'aide d'une masse à base de polyuréthane, à dureté shore élevée, allant par exemple de 30 à 80 Sh.D, et que le scellement présente au niveau de la transition entre la partie peu dure et la partie dure, une lentille secondaire (7) qui se forme en raison de la forme et de la formule de la masse de scellement.

2. Luminaire selon la revendication 1 **caractérisé par le fait que** la masse de scellement (6) est résistante à la lumière, optiquement neutre et étanche à l'eau.

3. Luminaire selon la revendication 1 ou 2, **caractérisé par le fait que** la masse de scellement (6) est une coulée, plus particulièrement une coulée à froid, et de préférence un polyuréthane élastomère composé essentiellement d'isocyanate et de polyol.

4. Luminaire selon l'une des revendications 1 à 3, **caractérisé par le fait que** la surface de contact de la platine du noyau métallique (3) et le boîtier métallique (1) sont dotés d'une pâte ou d'un film thermoconducteurs.

5. Luminaire selon l'une des revendications 1 à 4, **caractérisé par le fait que** les connexions pour l'électronique (5) et les diodes lumineuses (4) se trouvent à l'extérieur de la surface de contact de la platine du noyau métallique (3) et possèdent un filet.

6. Luminaire selon l'une des revendications 1 à 5, **caractérisé par le fait que** l'électronique (5) est une électronique de commande qui est équipée d'un capteur de température qui saisit indirectement la température du point hotspot de la diode lumineuse (4).

7. Luminaire selon l'une des revendications 1 à 6, **caractérisé par le fait que** l'électronique (5) comprend un rhéostat-régulateur d'intensité ayant la fonction d'un gradateur de lumière, ledit rhéostat-régulateur étant adressé par un capteur de température.

8. Luminaire selon l'une des revendications 1 à 7, **caractérisé par le fait que** les organes électroniques (5) sont liés entre eux et qu'ils sont connectés à un rhéostat-régulateur d'intensité à fonction de gradateur de lumière, ledit rhéostat-régulateur étant adressé par des capteurs de température.
